Europäisches Patentamt

European Patent Office

Office européen des brevets

(19)

(11) Numéro de publication: **0 196 715**
**B1**

# FASCICULE DE BREVET EUROPEEN

(45) Date de publication du fascicule du brevet:
**03.10.90**

(51) Int. Cl.⁵: **G11C 11/40, H01L 27/10**

(21) Numéro de dépôt: **86200477.7**

(22) Date de dépôt: **21.03.86**

(54) Mémoire à accès sélectif à charge active.

(30) Priorité: **29.03.85 FR 8504824**

(43) Date de publication de la demande:
**08.10.86 Bulletin 86/41**

(45) Mention de la délivrance du brevet:
**03.10.90 Bulletin 90/40**

(84) Etats contractants désignés:
**DE FR GB IT NL**

(56) Documents cités:
**EP-A- 0 029 717**
**GB-A- 1 405 285**

**IEEE JOURNAL FO SOLID-STATE CIRCUITS, vol. SC-13, no. 5, October 1978, pages 651-655, IEEE, New York, US; A. HOTTA et al.: "A high-speed low-power 4096 x 1 bit bipolar RAM"**
**Grebene, "Bipolar and MOS analog integrated circuit design, 1984, J. Willey and Sons, * p 125, fig 33 ***

(73) Titulaire: **PHILIPS COMPOSANTS, 117, quai du Président Roosevelt, F-92130 Issy les Moulineaux(FR)**
(84) Etats contractants désignés: **FR**

(73) Titulaire: **N.V. Philips' Gloeilampenfabrieken, Groenewoudseweg 1, NL-5621 BA Eindhoven(NL)**
(84) Etats contractants désignés: **DE GB IT NL**

(72) Inventeur: **Kwiatkowski, Jean-Claude, SOCIETE CIVILE S.P.I.D. 209 rue de l'Université, F-75007 Paris(FR)**
Inventeur: **Imbert, Guy, SOCIETE CIVILE S.P.I.D. 209 rue de l'Université, F-75007 Paris(FR)**

(74) Mandataire: **Jacquard, Philippe et al, Société Civile S.P.I.D. 156, Boulevard Haussmann, F-75008 Paris(FR)**

## Description

L'invention concerne une mémoire à accès sélectif (RAM) à charge active pour le stockage d'informations binaires, et comportant une pluralité de cellules organisées en lignes et en colonnes, chaque cellule comportant un premier et un deuxième transistor d'un premier type comportant chacun d'une part un premier et un deuxième émetteur, les premiers émetteurs étant connectés entre eux et les deuxième émetteurs étant connectés chacun à un conducteur de sélection de colonne, d'autre part, une base connectée au collecteur respectivement d'un troisième et d'un quatrième transistor du deuxième type opposé audit premier type et enfin un collecteur connecté à la base respectivement du troisième et du quatrième transistor, le collecteur du troisième transistor étant connecté à la base du quatrième transistor et vice-versa, et les émetteurs du troisième et du quatrième transistor étant connectés entre eux et à un conducteur de sélection de ligne.

Des mémoires à semiconducteur du type indiqué sont bien connues des spécialistes, tant en ce qui concerne leur organisation générale que le fonctionnement de chacune des cellules élémentaires où se trouve stockée l'information sous la forme de deux états possibles de conduction, un état de conduction dans une demi-cellule, (par exemple, premier et troisième transistor), cet état imposant le blocage de l'autre demi-cellule qui lui est associée (dans ce cas, deuxième et quatrième transistor).

Une cellule du type à transistors complémentaires est décrite notamment dans le brevet des Etats-Unis d'Amérique n° 4 257 059.

On sait que, lorsqu'une demi-cellule est dans l'état passant, les deux transistors complémentaires de cette demi-cellule sont saturés au point que le produit de leur gain respectif soit égal à 1. Ceci est vrai indépendamment de la valeur du courant qui y circule de sorte que, même aux bas niveaux de courant tels qu'ils sont utilisés pour le maintien de l'information, de l'ordre de quelques microampères, les transistors de la demi-cellule en question sont encore fortement saturés.

Le phénomène de saturation entraîne un inconvénient sur lequel il convient de s'expliquer plus en détail. Dans ce qui suit, pour simplifier et en se référant à la pratique courante, les premier et deuxième transistors du premier type de conduction, multi-émetteurs, seront choisis du type NPN et les transistors du second type seront des PNP.

Considérons, parmi une colonne de cellules, la sélection d'une cellule particulière, par exemple en vue de la lecture. Cette sélection a été déterminée par une élévation de la tension du conducteur de sélection de ligne qui est connecté à cette cellule particulière. Au sein de la cellule, particulière, l'une des demi-cellules est passante de sorte que le conducteur correspondant de lecture/écriture ou conducteur de sélection de colonne voit également son potentiel se relever puisque le deuxième émetteur de son transistor NPN, (par exemple le premier transistor), débite le courant de sélection sur ce conducteur de lecture/écriture. Les autres cellules de la même colonne, qui ne sont pas sélectionnées à cet instant, sont seulement soumises au courant de maintien. Certaines de ces autres cellules ont leur demi-cellules à l'état passant du même côté que la cellule particulière sélectionnée. Le deuxième émetteur de leur premier transistor NPN, est rappelons-le connecté au même conducteur de lecture/écriture. Il s'ensuit que pour ces autres cellules de la colonne, chaque deuxième émetteur se trouve polarisé en inverse, ou bien en direct sous une tension inférieure à une tension directe de diode ($V_{be}$). Ces transistors fonctionnent en inverse, étant donné que le premier émetteur met en saturation ceux-ci et donc ouvre leur jonction base-collecteur. Il s'ensuit un courant inverse indésirable qui circule dans ces émetteurs, qui jouent le rôle de collecteurs.

Outre que le courant inverse mentionné peut s'élever, pour une seule cellule, à une fraction très notable de la valeur du courant de maintien risquant ainsi de perturber gravement le fonctionnement de cette cellule, ce courant se trouve également cumulé le long d'un conducteur de lecture/écriture et peut être ainsi multiplié par un nombre qui peut atteindre le nombre de cellules (moins une) contenues dans une colonne. Dans le cas de mémoires de grande capacité, le courant de fuite total sur une colonne peut devenir ainsi une fraction non négligeable du courant de sélection lui-même créant de ce fait, des désordres importants notamment au niveau des circuits périphériques de lecture/écriture.

De plus, la valeur du courant inverse mentionné dépend de la valeur du gain inverse des transistors NPN, gain inverse que l'on maîtrise difficilement en pratique, et qui peut fluctuer d'un lot de fabrication à une autre.

L'invention a pour but de remédier aux difficultés mentionnées plus haut, au moins dans une large mesure.

Une mémoire à accès sélectif selon l'invention se caractérise en ce que, afin de diminuer le courant inverse des cellules non sélectionnées, une diode formée par une diode additionnelle est connectée en parallèle sur la jonction émetteur-base de chacun des troisième et quatrième transistors de chaque cellule et dans le même sens que ladite jonction.

La modification des cellules selon l'invention telles que définies ci-dessus non seulement est compatible avec le perfectionnement connu en soi du brevet GB 1 405 285 (FERRANTI), dans le contexte assez différent des cellules à charge résistive, mais encore elle permet d'obtenir avec celui-ci un cumul d'effets sur le courant inverse. Ledit perfectionnement consiste rappelons-le, à munir les premier et deuxième transistors de chaque cellule d'un troisième émetteur court-circuité avec la base du transistor correspondant. Ceci ne diminue pas la valeur totale du courant inverse dans la demi-cellule concernée, mais une part importante de celui-ci est générée à partir du courant de base du transistor correspondant diminuant d'autant le courant indésirable dans le conducteur de colonne.

Selon une variante, ladite diode est constituée par la jonction collecteur-base d'un transistor de dérivation du premier type, dont l'émetteur et la base sont court-circuités entre eux et connectés audit conducteur de sélection de ligne.

Selon un mode de réalisation de cette variante, chacun des premier et deuxième transistors multi-émetteurs de chaque cellule est un transistor vertical dont le collecteur est constitué par une couche enterrée dont la base est constituée par une première région superficielle dans laquelle sont ménagés lesdits émetteurs, chacun des troisième et quatrième transistors de chaque cellule est un transistor latéral dont le collecteur est constitué par ladite première région superficielle, dont l'émetteur est constitué par une deuxième région superficielle séparée de la première par une première portion superficielle étroite prolongeant localement en surface la couche enterrée et qui constitue la base du transistor latéral, et le transistor de dérivation est un deuxième transistor vertical dont la région d'émetteur est ménagé dans la deuxième région superficielle qui constitue sa base et dont le collecteur est constitué par ladite couche enterrée. Ce mode de réalisation permet de mettre en oeuvre l'invention sans augmenter la dimension des cellules.

La région d'émetteur du deuxième transistor vertical peut être disposée au moins partiellement en dessous du conducteur de sélection qui assure ainsi le court-circuit entre son émetteur et sa base.

L'invention sera mieux comprise à la lecture de la description qui va suivre, donnée à titre d'exemple non limitatif en liaison avec les dessins qui représentent :

- la figure 1, un schéma de l'organisation des cellules au sein d'une mémoire selon l'art antérieur,
- la figure 2, un schéma électrique d'une cellule selon l'invention,
et la figure 3 un schéma de celle-ci incorporant ledit perfectionnement connu,
- les figures 4 et 5, deux variantes du schéma électrique de l'invention, la figure 7 incorporant ledit perfectionnement connu,
- les figures 6 et 7 respectivement en vue de dessus et en coupe verticale AA un mode de réalisation du schéma des figures 4 et 5.

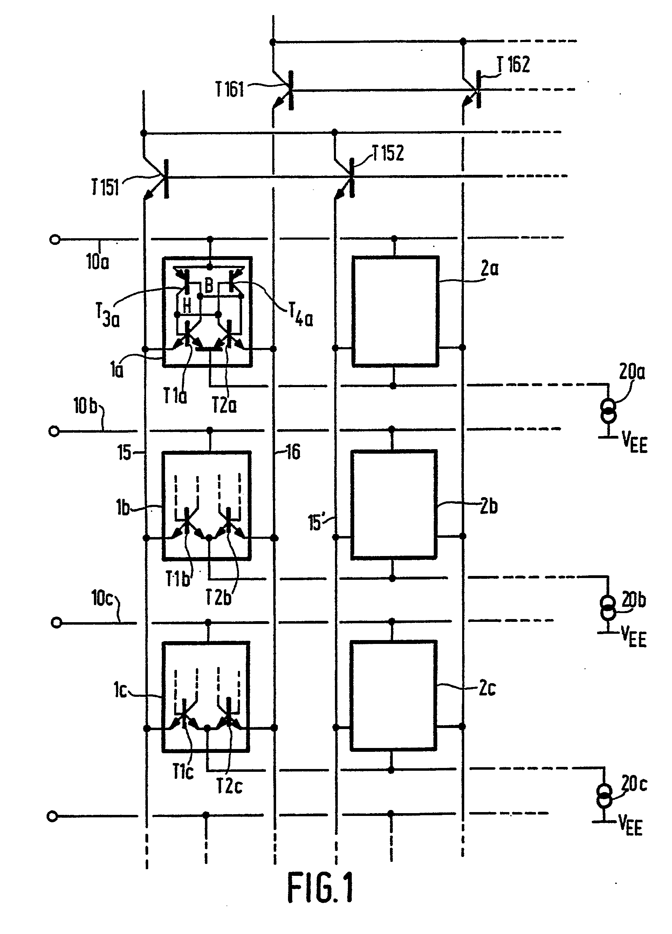

La figure 1 est un schéma d'une partie d'une mémoire à semiconducteurs selon l'art antérieur. Les rectangles 1a, 1b, 1c... représentent chacun une des cellules d'une colonne, tandis que les rectangles 2a, 2b et 2c... représentent les cellules de la colonne suivante. Les cellules d'une ligne, 1a, 2a... sont connectées en parallèle entre un conducteur de sélection de ligne 10a et une source de courant de maintien 20a. De même, les cellules 1b 2b... de la ligne suivante sont connectées entre un conducteur de sélection de ligne 10b et une source de courant de maintien 20b. La même disposition se répète encore pour les lignes suivantes de cellules telles que 1c, 2c... les conducteurs de sélection de ligne tels que 10c et les sources de courant de maintien telles que 20c.

On a fait figurer, à propos de la cellule 1a, les éléments constitutifs d'une cellule à savoir un premier transistor T1a de type NPN à deux émetteurs, le premier de ces deux émetteurs, dit "émetteur de maintien", étant relié à la source de courant de maintien 20a. La base et le collecteur du transistor T1a sont connectés respectivement au collecteur et à la base du transistor T3a, de type PNP, pour former une demi-cellule. L'émetteur du transistor T3a est connecté au conducteur de sélection de ligne 10a. Le deuxième émetteur, dit "émetteur de sélection" du transistor T1a est relié à un conducteur de lecture/écriture 15 pour la lecture ou l'écriture de la mémoire. L'ensemble formé à partir des transistor T1a et T3a constitue une première demi-cellule, tandis qu'un transistor T2a de type NPN, à deux émetteurs est associé à un transistor T4a, de type PNP, pour former une seconde demi-cellule identique à la première demi-cellule. Ces deux demi-cellules se trouvent ainsi connectées en parallèle entre le conducteur de sélection de ligne 10a et la source de courant de maintien 20a. La première et la seconde demi-cellule sont interconnectées entre elles de manière connue par couplage croisé, la base et le collecteur du transistor T1a étant connectés respectivement au collecteur et à la base du transistor T2a. L'émetteur de maintien du transistor T2a est relié à la source de courant de maintien 20a, alors que l'émetteur de sélection du même transistor est relié à un autre conducteur de lecture/écriture 16, pour la lecture ou l'écriture d'une information d'état qui est l'inverse de celle du conducteur 15.

Les autres cellules de la mémoire sont constituées d'éléments semblables. Au sein des cellules 1b et 1c, on a seulement fait figurer les transistors NPN multi-émetteurs T1b, T1c, et T2b, T2c, dont la fonction est respectivement similaire de celle des transistors T1a et T2a.

Aux conducteurs 15 et 16 de la première colonne, sont connectés respectivement les transistors de lecture/écriture T151 et T161 associés à cette colonne. De même, pour les colonnes suivantes, telles que celle représentée par les cellules 2a, 2b, 2c..., d'autres transistors de lecture/écriture sont connectés aux conducteurs de colonnes, transistors représentés par T152 et T162 sur la figure. Dans l'ensemble des transistors T151, T152..., les bases sont réunies entre elles et les collecteurs également. Une disposition similaire est utilisée en ce qui concerne l'ensemble des transistors T161, T162...

On va maintenant préciser, à l'aide des valeurs numériques relevées sur un exemple pratique, la difficulté qui se présente lorsqu'on utilise une telle mémoire de l'art antérieur, difficulté à laquelle l'invention se propose de remédier.

On supposera que l'on a sélectionné la ligne 10a et que l'on cherche à faire la lecture de la colonne 1a, 1b, 1c par les conducteurs 15 et 16. Supposons encore qu'à cet instant, toutes les demi-cellules sont à l'état passant du côté gauche de la figure, c'est-à-dire que les transistors T1a, T3a, T1b, T1c conduisent (la base de T1a, T1b... est au niveau haut H et celle de T1b, T2b... au niveau bas B). Selon une pratique courante en technique ECL, le niveau haut H est à -1,6 V et le niveau bas B est à -2,4V.

Les courants de maintien, par demi-cellule, ont été choisis de 25μA environ tandis que le courant de lecture est prévu de l'ordre de 1000 µA. Les conducteurs de sélection 10b, 10c des lignes non sélectionnées sont portés à -2,6 volt alors que le conducteur sélectionné 10a est porté à un potentiel de -1,6 volt. Le conducteur de colonne 15 se trouve à -2,4 volt, soit 0,8 volt plus bas que H, l'essentiel de cette chute de tension étant représenté par le $V_{be}$ du transistor T1a dont l'émetteur débite sur le conducteur de colonne 15. Le niveau de lecture

$$\frac{H + B}{2}$$

est présent sur la base du transistor T151.

La tension des conducteurs de sélection de ligne 10b et 10c de -2,6 volt est reportée avec une légère chute de tension sur la base du transistor T1b et sur celle du transistor T1c puisque, par hypothèse, ces transistors sont dans un état passant par leur émetteur de maintien. Comme les transistors T1b et T1c sont par ailleurs dans un état saturé provoqué par le courant de maintien débité par leur émetteur de maintien, leur jonction base-collecteur se trouve polarisée au voisinage du sens direct de ces jonctions.

Les conditions défavorables sont alors réunies pour que les transistors T1b et T1c travaillent en fonctionnement inverse, cette fois-ci non saturé, au niveau de leurs émetteurs de sélection $E_2$, c'est-à-dire que les rôles des émetteurs de sélection $E_2$ et des collecteurs se trouvent inversés par rapport à leur désignation habituelle.

On peut constater qu'en pratique, il entre effectivement un courant indésirable, dit "inverse", dans l'émetteur de sélection $E_2$ de chacun des transistors T1b et T1c, courant dont la valeur est de l'ordre de plusieur uA par émetteur. Outre qu'au niveau d'une cellule, ce courant n'est pas négligeable par rapport au courant de maintien et qu'il peut compromettre le fonctionnement des transistors PNP associés, du fait que ceux-ci sont appelés à travailler sous un courant beaucoup plus faible que prévu, les courants inverse des cellules 1b, 1c, etc... d'une même colonne s'additionnent sur un conducteur de colonne tel que le conducteur 15. Dans le cas d'une mémoire de forte capacité, ayant par exemple 64 cellules par colonne, la somme des courants inverse peut devenir une fraction non négligeable du courant de sélection lui-même, entraînant ainsi des perturbation sérieuses dans le fonctionnement des circuits de lecture/écriture d'une colonne.

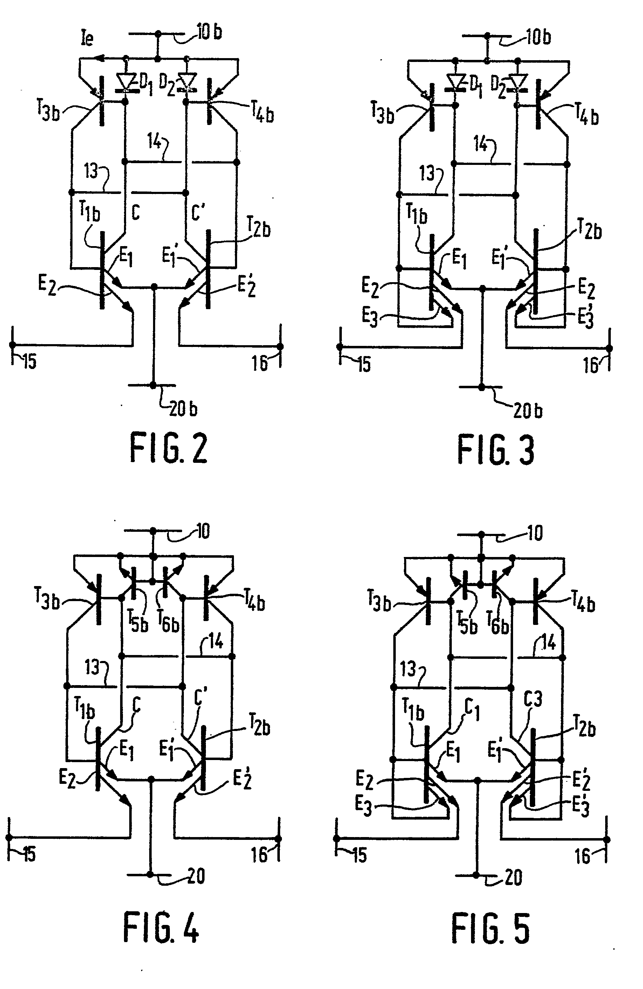

On a représenté à la figure 2 une cellule particulière, référencée 1b, et qui n'est autre que la cellule 1b de la figure 1 modifiée selon l'invention, les éléments communs avec l'art antérieur conservant par ailleurs la même référence. Selon l'invention, on dispose une diode ($D_1$, $D_2$) en parallèle dans chacun des trajets émetteur-base des transistors respectivement T3b et T4b et dans le même sens. En d'autres termes, pour des transistors T3b et T4b du type PNP, les diodes $D_1$ et $D_2$ sont dans le sens direct entre le conducteur de sélection de ligne 10b et la base desdits transistors.

On pourrait penser a priori que cette adjonction serait pénalisante du fait que ces diodes $D_1$ et $D_2$, du fait qu'elles dérivent du courant devant passer dans le transistor, ont pour effet de faire chuter le gain, l'ensemble diode-transistor associé ayant en effet un gain nettement plus faible que le transistor seul et d'autant plus faible que les diodes dérivent plus de courant.

L'invention repose tout d'abord sur le fait que, tant que le produit des gains des deux transistors reste suffisamment supérieur à l'unité, il est possible de conserver la stabilité de la cellule.

Le deuxième point important est la constatation par la Demanderesse que le paramètre qui détermine directement la valeur du courant inverse n'est pas un paramètre de courant, comme l'enseigne l'art antérieur, mais un paramètre de tension : il s'agit de la valeur de la tension collecteur-base $V_{bc}$ de transistor T1b ou T2b, selon le cas, et la variation du courant inverse est très rapide (division par deux pour une diminution de la tension $V_{bc}$ de 18 mV).

Le troisième point important est l'utilisation du fait que, si c'est le transistor T1b par exemple qui est traversé par ledit courant inverse, l'autre transistor T3b de la même demi cellule est à l'état saturé. Dans ce cas, la diode D1 produit une dérivation du courant d'émetteur $I_e$ du transistor T3b et la tension émetteur-base $V_{be}$ diminue. (de 18mV pour une division par deux du courant Ic).

La tension émetteur-collecteur $V_{ce}$ déjà faible (de l'ordre de 50 mV) diminue également, mais d'une quantité inférieure à la diminution du $V_{be}$ de T3b car l'état saturé du transistor T3b n'est que faiblement modifié. La tension du collecteur du transistor T1b étant plus basse que celle de sa base, (la jonction base-collecteur est presque ouverte) la tension collecteurbase $V_{bc}$ du transistor T1b diminue, ce qui produit une diminution du courant de fuite.

A titre d'exemple on prend une diode D1 dérivant 60% du courant d'émetteur du transistor T3b soit une division du courant Ie par 2,5, la tension de la base de T2b remonte de 25mV, et donc celle du collecteur de T1b, et la tension du collecteur de T2b remonte de 10mV seulement, et donc celle de la base de T1b. Globalement, la tension $V_{cb}$ des transistors T1b diminue de 25-10=15mV. Il en résulte une diminution du courant de fuite dans un rapport égal à peu près à 1,79.

Selon la figure 3, les transistors T1b et T2b sont chacun pourvus d'un troisième émetteur respectivement $E_3$ et $E'_3$ court-circuités avec la base, ainsi qu'il est connu en soi du brevet GB 1 405 285 (FERRANTI) précité. On obtient de manière remarquable un cumul des résultats procurés par les diode $D_1$ et $D_2$ d'une part et les émetteur $E_3$ et $E'_3$ d'autre part. En effet, ainsi qu'il a été mentionné ci-dessus, c'est la tension collecteur-base $V_{bc}$ des transistors T1b et T2b qui est déterminante pour la valeur du courant de fuite. L'émetteur supplémentaire $E_3$, si c'est la demi-cellule de gauche qui est saturée, fournit une partie du courant de fuite, par exemple 50% de celui-ci si les émetteurs $E_2$ et $E_3$ ont la même surface, la valeur totale du courant de fuite restant la même que dans le cas de la figure 2.

Dans l'exemple ci-dessus, le courant de fuite dans le conducteur de colonne 15 est encore divisé par 2 par rapport au cas de la figure 2.

Selon les figures 4 et 5 dans lesquelles les mêmes éléments portent les mêmes références que dans les figures 3 et 4, les diodes $D_1$ et $D_2$ sont constituées par la jonction collecteur-base respectivement de transistors $T_{5b}$ et $T_{6b}$ du type opposé à celui des transistors $T_{3b}$ et $T_{4b}$. L'émetteur et la base des transistors $T_{5b}$ et $T_{6b}$ sont court-circuités et connectés au conducteur de sélection de ligne 10. Le collecteur des transistors $T_{5b}$ et $T_{6b}$ est connecté à la base respectivement des transistors $T_{3b}$ et $T_{4b}$. Dans le cas où les transistors $T_{3b}$ et $T_{4b}$ sont du type PNP, sa désaturation est facilitée dans une large mesure par la présence de la jonction collecteur-base des transistors $T_{5b}$ et $T_{6b}$ qui est intrinsèquement plus rapide.

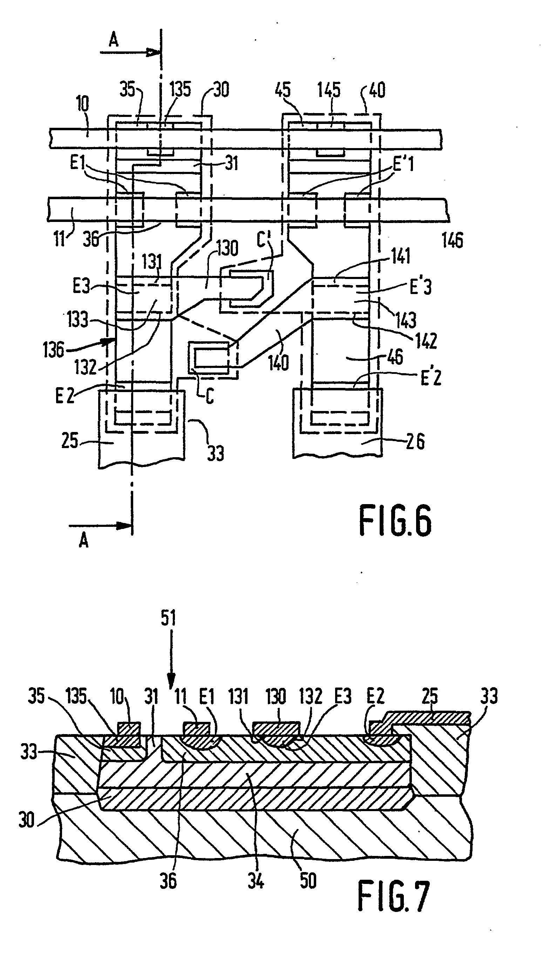

Selon les figures 6 et 7, chaque demi-cellule est réalisée en surface d'un substrat 50 dans un caisson isolant respectivement 51 et 52, délimité par une couche isolante 33 par exemple en $SiO_2$. Le caisson 51 comporte, par exemple pour un substrat de type p, une couche de contact fortement dopée $N^+$ formant le fond du caisson 51, surmontée d'une couche semi-conductrice enterrée 34 dopée N formant le collecteur du transistor $T_{1b}$. A partir de la surface sont réalisées une première région superficielle 36 du type $P^+$ constituant la base du transistor $T_{1b}$ présentant des régions d'émetteur $E_1$, $E_2$ et éventuellement $E_3$, du type $n^+$ et une deuxième région superficielle 35 également $p^+$ séparée de la première par une première portion superficielle étroite 31 prolongeant localement en surface la couche enterrée de collecteur 34.

En d'autres termes, les transistors $T_{1b}$ et $T_{2b}$ ($E_1$, $E_2$, $E_3$, 36, 34) sont verticaux et les transistors $T_{3b}$ et $T_{4b}$ (35, 31, 36) sont latéraux.

La figure 6 montre plus particulièrement comment sont disposées les métallisations.

Il est a remarquer que les dessins des figures 6 et 7 ne sont que schématiques et que les proportions ne sont pas respectées volontairement pour plus de clarté. On n'a pas représenté sur ces figures certaines couches isolantes de surface. Pour la commodité, les bandes métalliques servant aux contacts sur les différentes régions du corps semiconducteur ont été représentées plus étroites que les régions correspondantes alors qu'en pratique, elles sont réalisées plus larges que les fenêtres de contact et reposent partiellement sur une couche isolante.

Sur la figure 6 donc, on remarquera tout d'abord que les couches enterrées 30 et 40, qui s'étendent respectivement sous les îlots 51 et 52 se prolongent sous des prises de contact collecteur C et C'. L'oxyde profond 33 a en effet une épaisseur telle qu'il laisse subsister une part importante de la couche enterrée dans les zones où l'un et l'autre sont prévus simultanément, notamment dans lesdites zones de contact collecteur C et C'.

L'émetteur $E_1$ est réalisé en deux parties, un conducteur 11 de source de courant de maintien interconnectant les émetteurs $E_1$ et $E'_1$ des cellules d'une même ligne étant isolé de la région de base 36, entre ces deux parties, par une couche isolante par exemple d'oxyde. Cette disposition est connue du brevet français n° 2 413 782 au nom de la demanderesse.

L'autre interconnexion de ligne 10 est réalisée par un conducteur de sélection de ligne connectant électriquement les régions d'émetteur 35 et 45 des cellules d'une même ligne.

Les connexions de colonne sont réalisées par les métallisation 25 et 26 de sélection de colonne, lesquelles interconnectent les émetteurs $E_2$ d'une même colonne pour la métallisation 25 et les émetteurs $E'_2$ d'une même colonne pour la métallisation 26.

Les connexions électriques internes de la cellule sont réalisées par des métallisations 130 et 140. La métallisation 130 connecte la base 36 du transistor $T_{1b}$ au collecteur C' du transistor $T_{2b}$ et la métallisation 140 la base 46 du transistor $T_{2b}$ au collecteur C du transistor $T_{1b}$.

Les émetteurs $E_3$ et $E'_3$, éventuellement présents, sont disposés sous des régions 133 et 143 des métallisations 130 et 140 qui les court-circuitent avec la base respectivement 36 et 46 des transistors $T_{1b}$ et $T_{2b}$. Les régions d'émetteur $E_3$ et $E'_3$ sont généralement plus étroites que les régions respectivement 133 et 143, qui débordent de part et d'autre respectivement en 131 et 132, et 141 et 142.

De ce fait, le fonctionnement des transistors $T_{1b}$ et $T_{2b}$ ne se trouve pas perturbé, en ce qui concerne ses émetteurs $E_1$ et $E_2$, par sa résistance de base pincée par l'émetteur supplémentaire $E_3$.

Les transistors $T_{5b}$ et $T_{6b}$ sont des transistors verticaux dont l'émetteur est constitué par une région de type $n^+$ respectivement 135 et 145, dont la base est constituée respectivement par les régions 35 et 45 c'est-à-dire l'émetteur des transistors $T_{3b}$ et $T_{4b}$ et le collecteur est constitué par les régions 34 et 30 précitées. Les régions 135 et 145 sont situées au moins partiellement en-dessous de la métallisation 10 laquelle réalise le court-circuit émetteur-base des transistors $T_{5b}$ et $T_{6b}$. De préférence les régions 135 et 145 sont situées complétement en dessous de la métallisation 10, dans les mêmes conditions que les régions d'émetteur $E_3$ et $E'_3$. Elles occupent une fraction de la surface des régions 35 et 45 et leur dopage peut avantageusement être le même que celui des régions d'émetteur $E_1$ à $E_3$.

Le procédé de réalisation d'une mémoire à semiconducteur intégrant une pluralité de cellules telles que décrites aux figures 6 et 7 ne présente pas de difficulté particulière et a recours aux techniques connues utilisées dans la fabrication de circuits intégrés à isolement latéral par oxyde profond, notamment de circuit ECL. On peut se reporter, par exemple, aux informations données dans la demande de brevet français n° 2 413 782, déjà citée, incorporées ici par référence, pour ce qui est des techniques générales de fabrication.

Lorsqu'on désire utiliser un procédé d'auto-alignement et que, notamment, les fenêtres de contact des émetteurs servent également à l'implantation ionique de ces émetteurs, il y a lieu pour réaliser des émetteurs ou régions supplémentaires, de prévoir une fenêtre de la largeur du contact de base, puis de la réduire par un masque de laque photosensible aux dimensions désirées pour l'émetteur ou la région supplémentaire, et d'effectuer alors son implantation. En retirant le masque de laque, on a alors une fenêtre de contact de base qui inclut l'émetteur ou la région supplémentaire. En utilisant un conducteur qui déborde de tous côtés à la périphérie des fenêtres de contact, on est assuré de réaliser le court-circuit recherché entre la base et l'émetteur supplémentaire.

**Revendications**

1. Mémoire à accès sélectif à charge active pour le stockage d'informations binaires et comportant une pluralité de cellules organisées en lignes et en colonnes, chaque cellule comportant un premier et un deuxième transistor d'un premier type comportant chacun, d'une part un premier et un deuxième émetteur, les premiers émetteurs étant connectés entre eux et les deuxièmes émetteurs étant connectés chacun à un conducteur de sélection de colonne, d'autre part une base connectée au collecteur respectivement d'un troisième et d'un quatrième transistor de type pnp, et enfin un collecteur connecté à la base respectivement du troisième et du quatrième transistor, le collecteur du troisième transistor étant connecté à la base du quatrième transistor et vice-versa, et les émetteurs du troisième et du quatrième transistor étant connectés entre eux et à un conducteur de sélection de ligne et comprenant une diode ($D_1$, $D_2$) en parallèle sur la jonction émetteur-base de chacun des troisième ($T_{3a}$, $T_{3b}$...) et quatrième ($T_{4a}$, $T_{4b}$...) transistors de chaque cellule, et dans le même sens que ladite jonction, caractérisée en ce que ladite diode ($D_1$, $D_2$) est constituée par la jonction collecteur-base d'un transistor de dérivation ($T_{5b}$, et $T_{6b}$) de type npn dont l'émetteur et la base sont court-circuités entre eux et connectés audit conducteur de sélection de ligne.

2. Mémoire selon la revendication 1, caractérisée en ce que les premier ($T_{1a}$, $T_{2a}$...) et deuxième ($T_{2a}$, $T_{2b}$...) transistors de chaque cellule sont chacun pourvus d'un troisième émetteur ($E_3$, $E'_3$) court-circuité avec la base du transistor correspondant.

3. Mémoire selon la revendication 2, caractérisée en ce que chacun des premier et deuxième transistors multi-émetteurs ($T_{1a}$, $T_{2a}$, $T_{1b}$, $T_{2b}$...) de chaque cellule est un transistor vertical dont le collecteur est constitué par une couche enterrée (34), dont la base est constituée par une première région superficielle (36) dans laquelle sont ménagés lesdits émetteurs, ($E_1...E_3$), en ce que chacun des troisième et quatrième transistors ($T_{3a}$, $T_{4a}$, $T_{3b}$, $T_{4b}$...) de chaque cellule est un transistor latéral dont le collecteur est constitué par ladite première région superficielle (36), dont l'émetteur est constitué par une deuxième région superficielle (35) séparée de la première par une première portion superficielle étroite (31) prolongeant localement en surface la couche enterrée (34) et qui constitue la base du transistor latéral et en ce que le transistor de dérivation ($T_{5b}$, $T_{6b}$) est un deuxième transistor vertical dont la région d'émetteur (135) est ménagée dans la deuxième région superficielle (35) qui constitue sa base et dont le collecteur est constitué par ladite couche enterrée (34).

4. Mémoire selon la revendication 5, caractérisée en ce que la région d'émetteur (135) du deuxième transistor vertical ($T_{5b}$, $T_{6b}$) est disposée au moins partiellement en-dessous du conducteur de sélection de ligne (10) qui assure ainsi le court-circuit entre son émetteur (135) et sa base (35).

**Claims**

1. A selectively accessible memory (RAM) having an active load for storing binary information and comprising a plurality of cells organized in lines and columns, each cell comprising a first and a second transistor of the NPN type each comprising on the one hand a first and a second emitter, the first emitters being connected to each other and the second emitters being each connected to a column selection conductor, and on the other hand a base connected to the collectors of a third and a fourth transistor, respectively, of the PNP type, and finally a collector connected to the bases of the third and the fourth transistor, respectively, the collector of the third transistor being connected to the base of the fourth transistor and conversely, while the emitters of the third and fourth transistors are connected to each other and to a line selection conductor and comprise a diode (D1, D2) in parallel to the emitter-base junction of the third (T3a, T3b, ...) and fourth (T4a, T4b, ...) transistors of each cell and having the same direction as the said junction, characterized in that, in order to reduce the inverse current of the non-selected cells, the said diode (D1, D2) is formed by the collector-base junction of a shunt transistor (T5b, T6b) of the NPN type whose emitter and base ar mutually short-circuited and connected to the said line selection conductor.

2. A memory as claimed in Claim 1, characterized in that the first transistors (T1a, T2a, ...) and second transistors (T2a, T2b, ...) of each cell are each provided with a third emitter (E3, E3) short-circuited with the base of the corresponding transistor.

3. A memory as claimed in Claim 2, characterized in that each of the first and second multi-emitter transistors (T1a, T2a, T1b, T2b, ...) of each cell is a vertical transistor, whose collector is constituted by a buried layer (34) and whose base is constituted by a first surface adjacent region (36), in which the said emitters (E1 ... E3) are formed, in that each of the third and fourth transistors (T3a, T4a, T3b, T4b ...) of each cell is a lateral transistor, whose collector is constituted by the first surface adjacent region (36), whose emitter is constituted by a second surface adjacent region (35), separated from the first region by a first surface adjacent narrow portion (31) prolonging the buried layer (34) locally at the surface and which constitutes the base of the lateral transistor, and in that the shunt transistor (T5b, T6b) is a second vertical transistor, whose emitter region (135) is formed in the second surface adjacent region (35), which constitutes it base, and whose collector is constituted by the said buried layer (34).

4. A memory as claimed in Claim 3, characterized in that the emitter region (135) of the second vertical transistor (T5b, T6b) is disposed at least in part under the line selection conductor (10), which thus ensures that a short-circuit between its emitter (135) and its base (35) is obtained.

## Patentansprüche

1. Randomspeicher mit aktiver Ladung zum Speichern binärer Daten mit einer Anzahl in Zellen und Spalten aufgeteilter Zellen, wobei jede Zelle einen ersten und einen zweiten npn-Transistor aufweist, die je einerseits einen ersten und einen zweiten Emitter aufweisen, wobei die ersten Emitter miteinander verbunden sind und die zweiten Emitter mit je einem Spaltenwahlleiter verbunden sind, und andererseits eine Basis aufweisen, die mit dem Kollektor eines dritten bzw. vierten pnp-Transistors verbunden ist, und zum Schluß einen Kollektor, der mit der Basis des dritten bzw. vierten Transistors verbunden ist, wobei der Kollektor des dritten Transistors mit der Basis des vierten Transistors und umgekehrt verbunden ist, und wobei die Emitter des dritten und vierten Transistors miteinander sowie mit einem Zeilenwahlleiter verbunden sind und eine Diode (D$_1$, D$_2$) aufweisen parallel zu dem Emitter-Basis-Übergang des dritten (T3a, T3b ...) sowie des vierten (T4a, T4b ...) Transistors jeder Zelle und in derselben Richtung wie der genannte Übergang, dadurch gekennzeichnet, daß die genannte Diode (D$_1$, D$_2$) durch den Kollektor-Basis-Übergang eines npn-Ableitungstransistors (T5b, und T6b) gebildet wird, wobei der Emitter und die Basis untereinander kurzgeschlossen und mit dem genannten Zeilenwahlleiter verbunden sind.

2. Speicher nach Anspruch 1, dadurch gekennzeichnet, daß die ersten (T1a, T2a ...) und zweiten (T2a, T2b ...) Transistoren jeder Zelle mit je einem dritten Emitter (E3, E'3) versehen sind, der mit der Basis des entsprechenden Transistors kurzgeschlossen ist.

3. Speicher nach Anspruch 2, dadurch gekennzeichnet, daß jeder der ersten und zweiten Transistoren mit mehreren Emittern (T1a, T2a, T1b, T2b ...) jeder Zelle ein vertikaler Transistor ist, dessen Kollektor durch eine vergrabene Schicht (34) gebildet ist, dessen Basis durch ein erstes an die Oberfläche grenzendes Gebiet (36) gebildet ist, in dem die genannten Emitter (E$_1$ ... E$_3$) gebildet sind, daß jeder der dritten und vierten Transistoren (T3a, T4a, T3b, T4b ...) jeder Zelle ein lateraler Transistor ist, dessen Kollektor durch das genannte erste an die Oberfläche grenzende Gebiet (36) gebildet ist, dessen Emitter durch ein zweites an die Oberfläche grenzendes Gebiet (35) gebildet ist, das durch einen ersten schmalen an die Oberfläche grenzenden Teil (31) von dem ersten Gebiet getrennt ist und sich örtlich an der Oberfläche der vergrabenen Schicht (34) erstreckt und die Basis des lateralen Transistors bildet, und daß der Ableitungstransistor (T5b,

T6b) ein zweiter vertikaler Transistor ist, dessen Emittergebiet (135) in dem zweiten an die Oberfläche grenzenden Gebiet (35) gebildet ist, das die Basis bildet und dessen Kollektor durch die genannte vergrabene Schicht (34) gebildet wird.

4. Speicher nach Anspruch 5, dadurch gekennzeichnet, daß das Emittergebiet (135) des zweiten vertikalen Transistors (T5b, T6b) wenigstens teilweise unterhalb des Zeilenwahlleiters (10) gebildet ist, was gewährleistet, daß zwischen dem Emitter (135) und der Basis (35) ein Kurzschluß erhalten wird.

EP 0 196 715 B1

FIG.1

FIG. 2

FIG. 3

FIG. 4

FIG. 5

FIG.6

FIG.7